# EUROPÄISCHE PATENTSCHRIFT

(11) **EP 4 188 049 B1**
(45) Veröffentlichungstag und Bekanntmachung des Hinweises auf die Patenterteilung: **17.09.2025**
(21) Anmeldenummer: 22209080.5
(22) Anmeldetag: 23.11.2022
(51) Int. Cl.: H05K 13/06

(54) **VORRICHTUNG ZUM SETZEN VON ELEKTRISCHEN LEITERELEMENTEN**
DEVICE FOR PLACING ELECTRICAL CONDUCTOR ELEMENTS
DISPOSITIF POUR POSER DES ÉLÉMENTS CONDUCTEURS ÉLECTRIQUES

(30) Priorität: 26.11.2021 DE 102021131150
(43) Veröffentlichungstag der Anmeldung: 31.05.2023
(73) Patentinhaber: Friedrich-Alexander-Universität Erlangen-Nürnberg, 91054 Erlangen (DE)
(72) Erfinder: Piechulek, Niklas, 91054 Erlangen (DE); Fröhlig, Simon, 91054 Erlangen (DE)
(74) Vertreter: Hafner & Kohl PartmbB

(56) Entgegenhaltungen:
- EP-A1- 3 614 821
- CN-A- 112 736 786
- US-A1- 2021 183 541

## Beschreibung

Die Erfindung betrifft eine Vorrichtung und ein Verfahren zum Setzen von Leiterelementen, insbesondere im Zusammenhang mit einem Anschließen der Leiterelemente an ein Anschlussbauteil.

Entsprechende Vorrichtungen und Verfahren sind aus dem Stand der Technik in einer Vielzahl an unterschiedlichen Ausführungsformen dem Grunde nach bekannt. Lediglich beispielhaft sei hierzu auf das Dokument WO 2020/038912 A1 zu verweisen, in welchem ein Verdrahtungsroboter zum Verdrahten von Montageplatten, Schaltschränken, etc. beschrieben ist.

Hauptaufgabe und -funktion entsprechender Vorrichtungen besteht im Zusammenhang mit einem Anschließen elektrischer Leiterelemente an ein elektrisches Anschlussbauteil, wie z. B. eine Federkraftklemme, insbesondere darin, die elektrischen Leiterelemente, gegebenenfalls kraftbeaufschlagt, in einer definierten Ausrichtung und/oder Position in ein elektrisches Anschlusselement einzusetzen, um eine mechanisch stabile, elektrische leitfähige elektrische Kontaktierung herzustellen. Analoges gilt für andere Anwendungen, in welchen Leiterelemente an ein Anschlussbauteil anzuschließen sind.

Entsprechende Vorrichtungen erfordern sonach typischerweise ein zumindest zeitweises Fixieren jeweiliger Leiterelemente, um diese in gewünschter Weise in der definierten Ausrichtung und/oder Position in ein jeweiliges Anschlusselement einzusetzen. Hierzu sind die bekannten Vorrichtungen bis dato mitunter mit Greifervorrichtungen ausgestattet, welche ein jeweiliges Leiterelement, insbesondere endseitig, greifen und in eine entsprechende Anschlussöffnung eindrücken.

Entsprechende Greifervorrichtungen sind insofern verbesserungswürdig, als diese aufgrund der Greiferkonstruktion in bestimmten Richtungen kein ausreichendes Fixieren der jeweiligen Leiterelemente gewährleisten und bisweilen, etwa aufgrund lokal zu hoher Krafteinwirkung, zu Abdrücken oder Beschädigungen in der Isolation des jeweiligen Leiterelements führen.

EP 3 614 821 A1 offenbart ein Prinzip einer Vorrichtung zum Setzen von Leiterelementen.

Der vorliegenden Erfindung obliegt, die Aufgabe eine demgegenüber verbesserte Vorrichtung zum Setzen von Leiterelementen, insbesondere im Zusammenhang mit einem Anschließen der Leiterelemente an ein Anschlussbauteil, anzugeben.

Die Aufgabe wird durch die Gegenstände der unabhängigen Ansprüche gelöst. Die abhängigen Ansprüche betreffen mögliche Ausführungsformen der Gegenstände der unabhängigen Ansprüche.

Ein erster Aspekt der Erfindung betrifft eine Vorrichtung zum Setzen von Leiterelementen, insbesondere im Zusammenhang mit einem Anschließen der Leiterelemente an ein Anschlussbauteil. Die Vorrichtung ist sonach zum Setzen von Leiterelementen, insbesondere im Zusammenhang mit einem Anschließen der Leiterelemente an ein Anschlussbauteil, eingerichtet.

Unter einem "Setzen" ist typischerweise ein, gegebenenfalls kraftbeaufschlagtes, Einführen wenigstens eines entsprechenden Leiterelements in eine Anschluss- oder Kontaktöffnung eines Anschlussbauteils zu verstehen.

Unter einem Anschlussbauteil kann ein elektrisches Anschlussbauteil zu verstehen sein. Ein entsprechendes elektrischen Anschlussbauteil kann beispielsweise eine elektrische Klemme, wie z. B. eine Federkraftklemme, oder ein elektrischer Klemmenanschluss, wie z. B. ein gegebenenfalls auf einer Leiterplatte angeordneter oder ausgebildeter Federkraftklemmenanschluss sein.

Unter einem Leiterelement kann ein elektrisches Leiterelement zu verstehen sein. Ein elektrisches Leiterelement kann beispielsweise ein Draht, ein Kabel, eine Ader, eine Litze, etc. verstanden werden. Ein entsprechendes Leiterelement kann zumindest abschnittsweise mit einer elektrischen Isolierung versehen sein.

Unter einem Leiterelement kann jedoch auch ein optisches Leiterelemente, z. B. in Form von Glas- oder Polymerleitern, oder ein Medienführendes Leiterelement zu verstehen sein.

Unabhängig von seiner konkreten Ausführung kann es sich bei einem Leiterelement um ein, insbesondere im Hinblick auf die Längenabmessung, vorkonfektioniertes Leiterelement oder - z. B. im Sinne eines Halbzeugs - um ein nicht vorkonfektioniertes Leiterelement, wie z. B. einen Endlosleiter, handeln.

Die, gegebenenfalls auch als Ausgabeeinrichtung zur Ausgabe von zu setzenden Leiterelementen bezeichenbare Vorrichtung umfasst eine Klemmeinrichtung zum bedarfsweisen bzw. zeitweisen Klemmen wenigstens eines vermittels der Vorrichtung zu setzenden Leiterelements. Die Klemmeinrichtung ist sonach zum bedarfsweisen bzw. zeitweisen Klemmen, d. h. im Allgemeinen zum bedarfsweisen bzw. zeitweisen Fixieren, wenigstens eines vermittels der Vorrichtung zu setzenden Leiterelements eingerichtet. Unter einem bedarfsweisen bzw. zeitweisen Klemmen eines Leiterelements kann im Allgemeinen auch ein bedarfsweises bzw. zeitweises Fixieren eines Leiterelements verstanden werden, die Klemmeinrichtung kann daher im Allgemein auch als Fixiereinrichtung verstanden werden.

Die Klemmeinrichtung ist durch wenigstens einen Lagerkörper und wenigstens einen Klemmkörper gebildet bzw. umfasst wenigstens einen Lagerkörper und wenigstens einen Klemmkörper, deren geometrisch-konstruktive wie auch funktionelle Gestaltung im Weiteren näher erläutert wird.

Der wenigstens eine Lagerkörper begrenzt wenigstens ein, gegebenenfalls auch als erstes Aufnahmevolumen bezeichenbares, Aufnahmevolumen zur Aufnahme eines Klemmkörpers. Der wenigstens eine Lagerkörper weist sonach wenigstens ein durch Wandungen des wenigstens einen Lagerkörpers begrenztes Aufnahmevolumen zur Aufnahme eines Klemmkörpers auf. Wie sich im Weitern ergibt, weist der wenigstens eine Lagerkörper typischerweise eine hohlzylinderartige bzw. hülsenartige Grundform auf. Entsprechend handelt es sich bei dem lagerkörperseitig begrenzten Aufnahmevolumen typischerweise um ein zylinderartiges Aufnahmevolumen.

Der wenigstens eine Lagerkörper ist typischerweise aus einem formstabilen bzw. starren Material bzw. einer formstabilen bzw. starren Materialstruktur gebildet; der wenigstens eine Lagerkörper ist sonach typischerweise nicht reversibel deformierbar. Ein entsprechendes Material kann z. B. ein harter Kunststoff oder ein Metall sein.

Der wenigstens eine Klemmkörper ist innerhalb des lagerkörperseitig begrenzten Aufnahmevolumens anordenbar bzw. angeordnet und begrenzt ein, gegebenenfalls auch als zweites Aufnahmevolumen bezeichenbares, Aufnahmevolumen zur Aufnahme eines Leiterelements. Der wenigstens eine Klemmkörper weist sonach wenigstens ein durch Wandungen des wenigstens einen Klemmkörpers begrenztes Aufnahmevolumen zur Aufnahme eines Leiterelements auf. Wie sich ebenso im Weiteren ergibt, weist auch der wenigstens eine Klemmkörper typischerweise eine hohlzylinderartige bzw. hülsenartige Grundform auf. Entsprechend handelt es sich bei dem klemmkörperseitig begrenzten Aufnahmevolumen typischerweise um ein zylinderartiges Aufnahmevolumen. Die Abmessungen, d. h. insbesondere die Außenabmessungen, des wenigstens einen Klemmkörpers sind dabei an die Abmessungen, d. h. insbesondere die Innenabmessungen, des wenigstens einen Lagerkörpers angepasst, sodass sich der wenigstens eine Klemmkörper innerhalb des lagerkörperseitig begrenzten Aufnahmevolumens anordnen lässt.

Der wenigstens eine Klemmkörper ist im Gegensatz zu dem wenigstens einen Lagerkörper aus einem reversibel elastisch-deformierbaren Material bzw. einer reversibel elastisch-deformierbaren Materialstruktur gebildet; der wenigstens eine Klemmkörper ist sonach reversibel deformierbar. Ein entsprechendes Material kann z. B. ein elastischer bzw. flexibler Kunststoff oder ein Elastomer sein oder ein solches umfassen.

Der wenigstens eine Klemmkörper ist aufgrund seiner reversibel elastisch-deformierbaren Eigenschaften sonach volumenveränderlich ausgebildet; das Volumen des wenigstens einen Klemmkörpers und damit auch das klemmkörperseitig begrenzte Aufnahmevolumen ist sonach gezielt veränderbar. Der wenigstens eine Klemmkörper ist sonach durch Änderung seines Volumens in wenigstens einen Klemmzustand, in welchem eine Klemmkraft auf ein in dem Aufnahmevolumen angeordneten Abschnitt eines Leiterelements ausübbar ist, und in wenigstens einen Nichtklemmzustand, in welchem keine Klemmkraft auf ein in dem Aufnahmevolumen angeordneten Abschnitt eines Leiterelements ausübbar ist, überführbar. Das Klemmkörpervolumen ist in dem wenigstens einen Klemmzustand typischerweise größer als das Klemmkörpervolumen in dem wenigstens einen Nichtklemmzustand, woraus sich eine auf das jeweilige Leiterelement wirkende Klemmkraft ergibt.

Durch die Überführung des wenigstens einen Klemmkörpers in den wenigstens einen Klemmzustand ist das jeweilige Leiterelement innerhalb des klemmkörperseitig begrenzten Aufnahmevolumens fixiert, sodass Bewegungen des Leiterelements, insbesondere in Längs- und/oder Umfangsrichtung, relativ zu dem wenigstens einen Klemmkörper (weitgehend) unmöglich sind. Insbesondere ist das jeweilige Leiterelement in dem wenigstens einen Klemmzustand zumindest abschnittsweise, insbesondere nahezu vollständig, gegebenenfalls sogar vollständig, form- und/oder kraftschlüssig umfangsmäßig von dem wenigstens einen Klemmkörper umschlossen, woraus sich die beschriebene Klemmung bzw. Fixierung des Leiterelements ergibt. Dies ermöglicht eine weitgehend homogene Krafteinwirkung auf das jeweilige Leiterelement, die unerwünschte Abdrücke oder Beschädigungen des jeweiligen Leiterelements ausschließen.

Durch die Überführung des wenigstens einen Klemmkörpers in den wenigstens einen Nichtklemmzustand ist das jeweilige Leiterelement nicht (mehr) innerhalb des klemmkörperseitig begrenzten Aufnahmevolumens fixiert, sodass Bewegungen des Leiterelements relativ zu dem wenigstens einen Klemmkörper möglich sind. Das jeweilige Leiterelement ist in dem wenigstens einen Nichtklemmzustand nicht mehr form- und/oder kraftschlüssig umfangsmäßig von dem wenigstens einen Klemmkörper umschlossen, sodass das jeweilige Leiterelement auch nicht (mehr) geklemmt bzw. fixiert ist.

Durch den Einsatz eines volumenveränderlichen Klemmkörpers ist ein besonderes Klemmkonzept zum bedarfsweisen Klemmen eines Leiterelements realisiert, welches die im Zusammenhang mit dem eingangs genannten Stand der Technik genannten Nachteile ausräumt. Insgesamt liegt sonach eine verbesserte Vorrichtung zum Setzen von Leiterelementen, insbesondere im Zusammenhang mit einem Anschließen der Leiterelemente an ein Anschlussbauteil, vor.

Der wenigstens eine Klemmkörper kann form- und/oder kraft- und/oder stoffschlüssig an dem wenigstens einen Lagerkörper befestigt sein, sodass der wenigstens eine Klemmkörper und der wenigstens eine Lagerkörper stabil miteinander verbunden sind. Form- und/oder kraftschlüssige Befestigungen können z. B. durch Klemm-, Rast-, Spann- oder Schraubbefestigungen realisiert sein. Stoffschlüssige Befestigungen können z. B. durch Klebe- oder Schweißbefestigungen realisiert sein. Der, wie erwähnt, reversibel elastisch-deformierbar ausgeführte wenigstens eine Klemmkörper kann sonach z. B. in dem wenigstens einen Lagerkörper eingeklebt sein, sodass nur die Kombination aus wenigstens einen Lagerkörper und dem wenigstens einen Klemmkörper zu dem beschriebenen klemmkörperseitigen Aufnahmevolumen führt.

An dieser Stelle ist anzumerken, dass grundsätzlich auch eine einstückige bzw. integrale Ausführung des wenigstens einen Klemmkörpers mit dem wenigstens einen Lagerkörper denkbar ist.

Der wenigstens eine Klemmkörper weist wenigstens einen mit einem, gegebenenfalls druckbeaufschlagten, Fluid - hierunter kann ein Gas und/oder eine Flüssigkeit versanden werden - befüllbaren Klemmkörperinnenraum auf, wobei die Änderung des Volumens des wenigstens einen Klemmkörpers durch Befüllung des wenigstens einen Klemmkörpers mit dem Fluid herbeiführbar ist. Entsprechend können Klemmzustände und Nichtklemmzustände des wenigstens einen Klemmkörpers mit unterschiedlichen Füllzuständen des wenigstens einen Klemmkörperinnenraums mit einem jeweiligen Fluid korrelieren. Sofern der wenigstens eine Klemmkörper mehrere, gegebenenfalls miteinander kommunizierende, Klemmkörperinnenräume aufweist, können die geometrische Gestalt des wenigstens einen Klemmkörpers in jeweiligen Klemmzuständen und damit verbunden die auf den jeweiligen Leiterelementabschnitt wirkenden Klemmkräfte durch eine bestimmte Anordnung und/oder Ausrichtung der Klemmkörperinnenräume gezielt variiert werden.

Um ein entsprechendes Fluid in den wenigstens einen Klemmkörperinnenraum zuzuführen und/oder aus dem wenigstens einen Klemmkörperinnenraum abzuführen, kann der wenigstens eine Lagerkörper und/oder der wenigstens eine Klemmkörper wenigstens eine Anschlussschnittstelle zum Anschließen einer das Fluid bereitstellenden Fluidbereitstellungseinrichtung aufweisen.

Das Überführen des wenigstens einen Klemmkörpers in den wenigstens einen Klemmzustand und/oder in den wenigstens einen Nichtklemmzustand kann sonach hydraulisch oder pneumatisch erfolgen. Grundsätzlich kommen für das Überführen des wenigstens einen Klemmkörpers in den wenigstens einen Klemmzustand und/oder in den wenigstens einen Nichtklemmzustand jedoch auch andere Prinzipien in Betracht; in diesem Zusammenhang ist lediglich beispielhaft auf mechanische, elektromechanische und/oder elektrische Aktoren zu verweisen.

Die Klemmeinrichtung kann entlang bzw. um wenigstens eine Bewegungsachse in eine, gegebenenfalls auch als erste Steckstellung bezeichenbare, erste Betriebsstellung und in wenigstens eine, gegebenenfalls als weitere Steckstellung bezeichenbare, weitere Betriebsstellung bewegbar gelagert sein. Derart kann sichergestellt werden, dass die Klemmeinrichtung für eine Vielzahl unterschiedlicher konkreter Anwendungen stets in gewünschter Weise relativ zu einem Anschlussbauteil ausgerichtet und/oder positioniert werden kann. Bewegungen der Klemmeinrichtung können z. B. dadurch realisiert sein, dass der Lagerkörper und der Klemmkörper mit einem in wenigstens einem Bewegungsfreiheitsgrad gelagerten Aufnahmekörper verbunden und sonach mit diesem (bewegungs)gekoppelt sind.

Eine Bewegungsachse kann grundsätzlich eine Translations- oder eine Rotationsachse (Drehachse) sein. Mithin kann die Klemmeinrichtung grundsätzlich in eine durch die Translationsachse definierte Translationsbewegung oder in eine durch die Rotationsachse definierte Rotationsbewegung (Drehbewegung bzw. Schwenkbewegung) versetzt werden. Kombinierte Bewegungen in einer oder mehreren Translations- und/oder Rotationsachsen sind grundsätzlich ebenso denkbar. Über eine in die erste Betriebsstellung bewegte, d. h., wie sich im Weiteren ergibt, insbesondere verschwenkte, Klemmeinrichtung kann z. B. ein erstes (freies) Ende eines jeweiligen Leiterelements gesetzt werden, über eine in die wenigstens eine weitere Betriebsstellung bewegte, d. h., wie sich im Weiteren ergibt, insbesondere verschwenkte, Klemmeinrichtung kann z. B. ein zweites (freies) Ende des jeweiligen Leiterelements gesetzt werden.

In einer konkreten Ausführungsform kann die Klemmeinrichtung um wenigstens eine Rotations- bzw. Schwenkachse in eine erste Betriebsstellung und in wenigstens eine weitere Betriebsstellung verdrehbar bzw. verschwenkbar gelagert sein. Die Dreh- bzw. Schwenkachse kann eine winklig, insbesondere rechtwinklig, zu einer z. B. durch die Längsachse des wenigstens einen Lagerkörpers und/oder des wenigstens einen Klemmkörpers definierte Zentralachse der Klemmeinrichtung ausgerichtet sein. Dreh- bzw. Schwenkbewegungen der Klemmeinrichtung können in wenigstens einer Dreh- bzw. Schwenkrichtung grundsätzlich in einem beliebigen Winkelbereich erfolgen.

Insbesondere können Dreh- bzw. Schwenkbewegungen der Klemmeinrichtung in einem Winkelbereich von wenigstens 180° erfolgen. Ausgehend von der ersten Betriebsstellung kann die Klemmeinrichtung sonach z. B. durch Drehen- bzw. Verschwenken um einen Winkel von wenigstens 180° in einer ersten Drehrichtung in die zweite Betriebsstellung überführt werden. Ausgehend von der zweiten Betriebsstellung kann die Rücküberführung der Klemmeinrichtung in die erste Betriebsstellung z. B. durch Drehen- bzw. Verschwenken um einen Winkel von wenigstens 180° in der ersten oder in einer zweiten Drehrichtung erfolgen. Derart kann auf einfache und praktikable Weise ein beidseitiges Setzen eines Leiterelements realisiert werden.

Zurückkommend auf die geometrisch-konstruktive Gestaltung des wenigstens einen Lagerkörpers und des wenigstens einen Klemmkörpers gilt Folgendes:
Der wenigstens eine Lagerkörper kann, wie erwähnt, eine hohlzylinderartige bzw. hülsenartige Grundform aufweisen, welche sich querschnittlich betrachtet in Umfangsrichtung zumindest um einen Winkelbereich von 180°, insbesondere von wenigstens 270°, weiter insbesondere von wenigstens 300°, erstreckt. Bei dem wenigstens einen Lagerkörper kann es sich sonach um einen längsgeschlitzten Hohlzylinder bzw. eine längsgeschlitzte Hülse handeln. Hieraus ergibt sich eine kanalartige längliche Geometrie des lagerkörperseitig begrenzten Aufnahmevolumens. Durch die Längsschlitzung des Lagerkörpers ist eine Möglichkeit der Entnahme des Klemmkörpers aus dem lagerkörperseitig begrenzten Aufnahmevolumen gegeben.

Gleichermaßen kann der wenigstens einen Klemmkörper eine hohlzylinderartige bzw. hülsenartige Grundform aufweisen, welche sich querschnittlich betrachtet in Umfangsrichtung zumindest um einen Winkelbereich von 180°, insbesondere von wenigstens 270°, weiter insbesondere von wenigstens 300°, erstreckt. Bei dem wenigstens einen Klemmkörper kann es sich sonach ebenso um einen längsgeschlitzten Hohlzylinder bzw. eine längsgeschlitzte Hülse handeln. Hieraus ergibt sich eine kanalartige längliche Geometrie des klemmkörperseitig begrenzten Aufnahmevolumens. Durch die Längsschlitzung des Klemmkörpers ist eine Möglichkeit der Entnahme des jeweiligen Leiterelements aus dem klemmkörperseitig begrenzten Aufnahmevolumen gegeben.

Die Vorrichtung kann neben der Klemmeinrichtung weitere funktionelle Bestandteile aufweisen, welche nachfolgend beispielhaft beschrieben sind:
Die Vorrichtung kann eine durch ein oder mehrere Halterungseinrichtungselemente gebildete Halterungseinrichtung zur Halterung der Klemmeinrichtung aufweisen. Die Halterungseinrichtung kann wenigstens eine, z. B. flanschartige bzw. -förmige, Befestigungsschnittstelle zur Befestigung einer, insbesondere (elektro)motorischen, Antriebseinrichtung aufweisen, welche zur Erzeugung einer die Klemmeinrichtung in dem oder wenigstens einen Bewegungsfreiheitsgrad versetzenden Antriebskraft eingerichtet ist.

Alternativ oder ergänzend kann die Vorrichtung wenigstens eine durch ein oder mehrere Förderungseinrichtungselemente gebildete Fördereinrichtung zur Förderung wenigstens eines Leiterelements in die Klemmeinrichtung und/oder aus der Klemmeinrichtung aufweisen. Die Fördereinrichtung kann wenigstens eine, insbesondere (elektro)motorische, Antriebseinrichtung aufweisen, welche zur Erzeugung einer ein jeweiliges Leiterelement in die Klemmeinrichtung und/oder aus der Klemmeinrichtung fördernden Förderkraft eingerichtet ist. Sofern die Vorrichtung mehrere Fördereinrichtungen aufweist, kann eine erste Fördereinrichtung einer im Weiteren beschriebenen Trenneinrichtung zur Auftrennung eines Endlosleiters in diskrete Leiterelemente vorgeschaltet und eine zweite Fördereinrichtung der Trenneinrichtung nachgeschaltet angeordnet oder ausgebildet sein.

Weiter alternativ oder ergänzend kann die Vorrichtung wenigstens eine durch ein oder mehrere, z. B. schneidenartige bzw. -förmige, Trennelemente gebildete Trenneinrichtung zur Auftrennung eines Endlosleiters in diskrete Leiterelemente aufweisen. Alternativ oder ergänzend die Trenneinrichtung gegebenenfalls auch zum zumindest abschnittsweisen Abtrennen einer Isolation eines Leiterelements eingerichtet sein. Die Trenneinrichtung kann wenigstens eine, insbesondere (elektro)motorische, Antriebseinrichtung aufweisen, welche zur Erzeugung einer ein jeweiliges Trennelement in eine Trennbewegung versetzenden Trennkraft eingerichtet ist. Die Trenneinrichtung kann, insbesondere zwischen die Klemmeinrichtung und die Fördereinrichtung geschaltet angeordnet oder ausgebildet sein.

Sofern vorhanden, können wenigstens zwei der vorgenannten Einrichtungen, d. h. die Klemmeinrichtung und/oder die Trenneinrichtung und/oder die Fördereinrichtung, eine gemeinsam vermittels wenigstens einer Manipulatoreinrichtung handhabbare Baugruppe bilden. Die Baugruppe weist typischerweise einen durch jeweilige kanalartige Abschnitte der Klemmeinrichtung, Trenneinrichtung und Fördereinrichtung, insbesondere durch eine fluchtende Anordnung dieser, gebildeten Ausgabekanal auf, über welchen ein Leiterelement durch die Baugruppe bewegbar ist. Entsprechende kanalartige Abschnitte sind im Falle der Klemmeinrichtung durch das klemmkörperseitig begrenzte Aufnahmevolumen gebildet.

Die Baugruppe umfasst typischerweise wenigstens eine Kopplungsschnittstelle, über welche sich die Baugruppe mit einer entsprechenden Manipulatoreinrichtung koppeln lässt. Die Kopplungsschnittstelle kann an wenigstens einer einen Bestandteil der Baugruppe bildenden Einrichtung, d. h. insbesondere der Klemmeinrichtung und/oder der Trenneinrichtung und/oder der Fördereinrichtung, angeordnet oder ausgebildet sein und z. B. eine mechanische Kopplung der Baugruppe mit der wenigstens einen Manipulatoreinrichtung ermöglichen. Eine mechanische Kopplung kann konkret z. B. durch eine Schraubverbindung realisiert sein; eine entsprechende Kopplungsschnittstelle kann sonach z. B. als Schraubverbindungsschnittstelle ausgebildet sein oder wenigstens eine solche umfassen. Eine entsprechende Manipulatoreinrichtung kann z. B. als ein Bestandteil eines Industrieroboters ausgebildet sein oder einen solchen umfassen.

Allen vorstehend genannten Antriebseinrichtungen kann wenigstens eine hardware-und/oder softwaremäßig implementierte Steuereinrichtung zugeordnet sein, über welche sich Steuerinformationen zur Steuerung des Betriebs der jeweiligen Antriebseinrichtungen erzeugen lassen. Entsprechende Steuerinformationen können einen kontinuierlichen, quasikontinuierlichen oder diskontinuierlichen Betrieb der jeweiligen Antriebseinrichtungen bedingen.

Die Vorrichtung kann mehrere Klemmeinrichtungen umfassen, welche sich in den geometrisch-konstruktiven Eigenschaften der jeweiligen Lagerkörper und/oder Klemmkörper unterscheiden, sodass im Hinblick auf die Abmessungen eines zu setzenden Leiterelements stets eine bestmöglich passende Klemmeinrichtung eingesetzt werden kann. Hieraus ergibt sich, dass eine jeweilige Klemmeinrichtung als austauschbares Klemmeinrichtungsmodul ausgebildet sein kann, welches z. B. mit den übrigen Bestandteilen einer entsprechenden Baugruppe bedarfsweise verbunden sein kann.

Ein zweiter Aspekt der Erfindung betrifft ein Verfahren zum Setzen von Leiterelementen, insbesondere im Zusammenhang mit einem Anschließen der Leiterelemente an ein Anschlussbauteil, vermittels einer Vorrichtung gemäß dem ersten Aspekt der Erfindung. Das Verfahren umfassend zumindest die Schritte: Überführen des wenigstens einen Klemmkörpers in wenigstens einen Klemmzustand, in welchem eine Klemmkraft auf ein in dem Aufnahmevolumen angeordneten Abschnitt eines Leiterelements ausübbar ist, insbesondere vor und während des Einführens des Leiterelements in eine Anschluss- oder Kontaktöffnung eines Anschlussbauteils, und/oder Überführen des wenigstens einen Klemmkörpers in wenigstens einen Nichtklemmzustand, in welchem keine Klemmkraft auf ein in dem Klemmkörpervolumen angeordneten Abschnitt eines Leiterelements ausübbar ist, insbesondere nach dem Einführen des Leiterelements in eine Anschluss- oder Kontaktöffnung eines Anschlussbauteils. Die Klemmeinrichtung kann im Rahmen des Verfahrens in wenigstens einem Bewegungsfreiheitsgrad bewegt werden. Alternativ oder ergänzend kann die Vorrichtung im Rahmen des Verfahrens, insbesondere durch Kopplung mit einer Manipulatoreinrichtung, in wenigstens einem Bewegungsfreiheitsgrad bewegt werden, um ein aus der Klemmeinrichtung ragendes freies Ende eines Leiterelements in eine für einen Setzvorgang zweckmäßige Ausrichtung und/oder Position relativ zu einer Anschluss- bzw. Kontaktöffnung zu verbringen.

Die Erfindung ist nachfolgend nochmals unter Bezugnahme auf die beigefügten Zeichnungen beschrieben, dabei zeigt:
Fig. 1 - 3 eine Prinzipdarstellung einer Vorrichtung zum Setzen von Leiterelementen gemäß einem Ausführungsbeispiel; und
Fig. 4 eine Prinzipdarstellung einer an einer Manipulatoreinrichtung angeordneten Vorrichtung zum Setzen von Leiterelementen gemäß einem Ausführungsbeispiel.

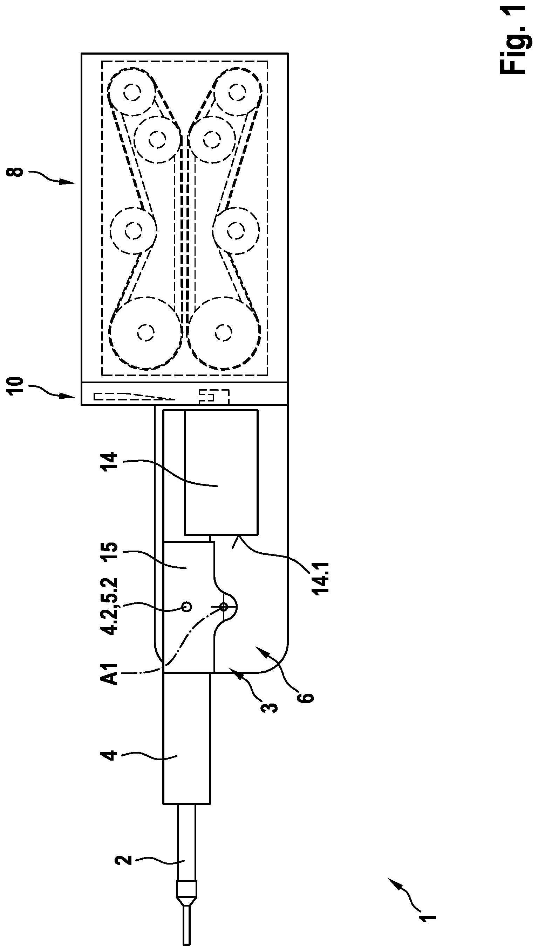

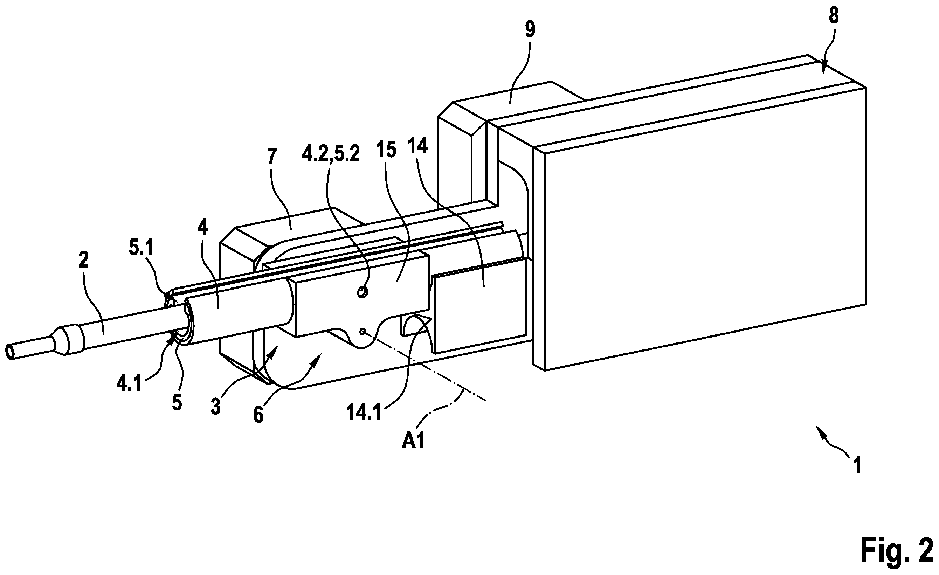

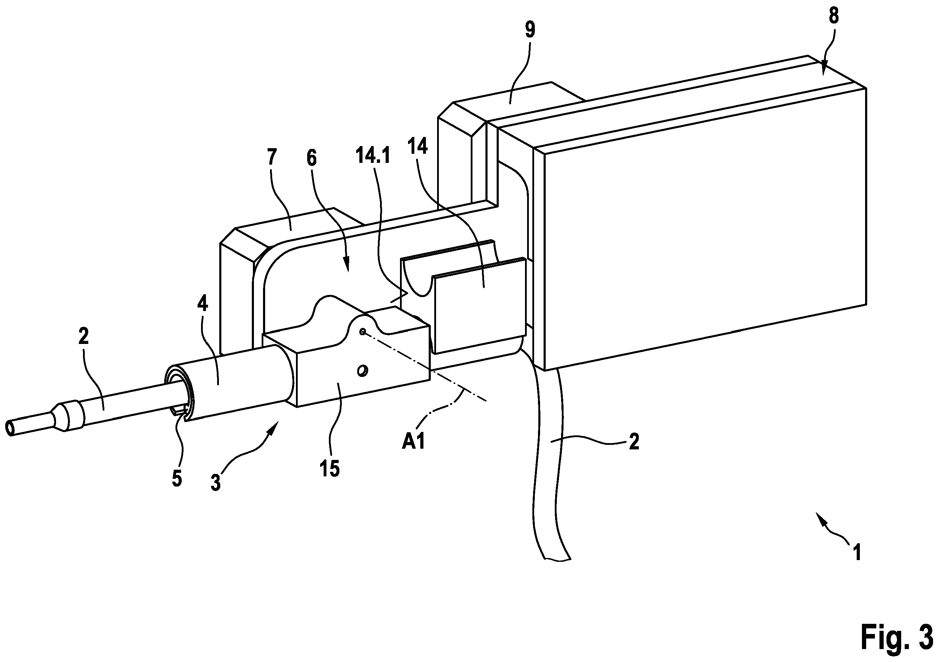

Die Fig. 1 - 3 zeigen eine Prinzipdarstellung einer Vorrichtung 1 zum Setzen von Leiterelementen 2 gemäß einem Ausführungsbeispiel in einer Seitenansicht (Fig. 1) und zwei perspektivischen Ansicht (Fig. 2, 3).

Die Vorrichtung 1 ist zum Setzen von Leiterelementen 2, wie z. B. Drähten, Kabeln, etc., insbesondere im Zusammenhang mit einem Anschließen der Leiterelemente an ein Anschlussbauteil (nicht gezeigt), wie z. B. ein elektrisches Anschlussbauteil, wie z. B. einer Federkraftklemme, eingerichtet.

Die, gegebenenfalls auch als Ausgabeeinrichtung zur Ausgabe von zu setzenden Leiterelementen bezeichenbare Vorrichtung 1 umfasst eine Klemmeinrichtung 3, welche zum bedarfsweisen bzw. zeitweisen Klemmen wenigstens eines vermittels der Vorrichtung 1 zu setzenden Leiterelements 2 eingerichtet ist. Unter einem bedarfsweisen bzw. zeitweisen Klemmen eines Leiterelements 2 kann im Allgemeinen auch ein bedarfsweises bzw. zeitweises Fixieren eines Leiterelements 2 verstanden werden, die Klemmeinrichtung 3 kann daher im Allgemein auch als Fixiereinrichtung verstanden werden.

Anhand der Fig. ist ersichtlich, dass die Klemmeinrichtung 3 durch einen Lagerkörper 4 und einen Klemmkörper 5 gebildet ist bzw. einen Lagerkörper 4 und einen Klemmkörper 5 umfasst.

Anhand der Fig. ist ferner ersichtlich, dass der Lagerkörper 4 ein, gegebenenfalls auch als erstes Aufnahmevolumen bezeichenbares, Aufnahmevolumen 4.1 zur Aufnahme des Klemmkörpers 5 begrenzt. Der Lagerkörper 4 weist sonach ein durch Wandungen begrenztes Aufnahmevolumen 4.1 zur Aufnahme des Klemmkörpers 5 auf. Der Klemmkörper 5 ist sonach innerhalb des lagerkörperseitig begrenzten Aufnahmevolumens 4.1 anordenbar bzw. angeordnet.

Der Lagerkörper 4 weist in den Ausführungsbeispielen eine längsgeschlitzte hohlzylinderartige bzw. hülsenartige Grundform auf. Entsprechend handelt es sich bei dem lagerkörperseitig begrenzten Aufnahmevolumen 4.1 um ein zylinderartiges Aufnahmevolumen. Ersichtlich erstreckt sich der Lagerkörper 4 querschnittlich betrachtet in den Ausführungsbeispielen in Umfangsrichtung zumindest um einen Winkelbereich von wenigstens 270°. Aus der längsgeschlitzten Hohlzylinder- bzw.

Hülsengeometrie ergibt sich eine kanalartige längliche Geometrie des lagerkörperseitig begrenzten Aufnahmevolumens 4.1. Durch die Längsschlitzung des Lagerkörpers 4 ist eine Möglichkeit der Entnahme des Klemmkörpers 5 aus dem lagerkörperseitig begrenzten Aufnahmevolumen 4.1 gegeben.

Der Lagerkörper 4 ist in den Ausführungsbeispielen aus einem formstabilen bzw. starren Material bzw. einer formstabilen bzw. starren Materialstruktur gebildet; der Lagerkörper 4 ist sonach typischerweise nicht reversibel deformierbar. Ein entsprechendes Material kann z. B. ein harter Kunststoff oder ein Metall sein.

Anhand der Fig. ist ebenso ersichtlich, dass der Klemmkörper 5 ein, gegebenenfalls auch als zweites Aufnahmevolumen bezeichenbares, Aufnahmevolumen 5.1 zur Aufnahme eines Leiterelements 2 begrenzt. Der Klemmkörper 5 weist sonach wenigstens ein durch Wandungen begrenztes Aufnahmevolumen 5.2 zur Aufnahme eines Leiterelements 2 auf.

Auch der Klemmkörper 5 weist in den Ausführungsbeispielen eine längsgeschlitzte hohlzylinderartige bzw. hülsenartige Grundform auf. Entsprechend handelt es sich bei dem klemmkörperseitig begrenzten Aufnahmevolumen 5.1 um ein zylinderartiges Aufnahmevolumen. Die Abmessungen, d. h. insbesondere die Außenabmessungen, des Klemmkörpers 5 sind an die Abmessungen, d. h. insbesondere die Innenabmessungen, des Lagerkörpers 4 angepasst, sodass sich der Klemmkörper 5 innerhalb des lagerkörperseitig begrenzten Aufnahmevolumens 4.1 anordnen lässt. Ersichtlich erstreckt sich auch der Lagerkörper 5 querschnittlich betrachtet in den Ausführungsbeispielen in Umfangsrichtung zumindest um einen Winkelbereich von wenigstens 270°. Aus der längsgeschlitzten Hohlzylinder- bzw. Hülsengeometrie ergibt sich ebenso eine kanalartige längliche Geometrie des klemmkörperseitig begrenzten Aufnahmevolumens 5.1. Durch die Längsschlitzung des Klemmkörpers 5 ist eine Möglichkeit der Entnahme des Leiterelements 2 aus dem klemmkörperseitig begrenzten Aufnahmevolumen 5.1 gegeben.

Der Klemmkörper 5 ist in den Ausführungsbeispielen im Gegensatz zu dem Lagerkörper 4 aus einem reversibel elastisch-deformierbaren Material bzw. einer reversibel elastisch-deformierbaren Materialstruktur gebildet; der Klemmkörper 5 ist sonach reversibel deformierbar. Ein entsprechendes Material kann z. B. ein elastischer bzw. flexibler Kunststoff oder ein Elastomer sein oder ein solches umfassen.

Der Klemmkörper 5 ist aufgrund seiner reversibel elastisch-deformierbaren Eigenschaften volumenveränderlich ausgebildet; das Volumen des Klemmkörpers 5 und damit auch das klemmkörperseitig begrenzte Aufnahmevolumen 5.1 ist sonach gezielt veränderbar. Der Klemmkörper 5 ist sonach durch Änderung seines Volumens in wenigstens einen Klemmzustand, in welchem eine Klemmkraft auf ein in dem Aufnahmevolumen 5.1 angeordneten Abschnitt eines Leiterelements 2 ausübbar ist, und in wenigstens einen Nichtklemmzustand, in welchem keine Klemmkraft auf ein in dem Aufnahmevolumen 5.1 angeordneten Abschnitt eines Leiterelements 2 ausübbar ist, überführbar. Das Klemmkörpervolumen ist in dem wenigstens einen Klemmzustand typischerweise größer als das Klemmkörpervolumen in dem wenigstens einen Nichtklemmzustand, woraus sich eine auf das jeweilige Leiterelement 2 wirkende Klemmkraft ergibt.

Wie z. B. die Fig. 1 - 3 zeigen, ist das Leiterelement 2 durch die Überführung des Klemmkörpers 5 in den wenigstens einen Klemmzustand innerhalb des klemmkörperseitig begrenzten Aufnahmevolumens 5.1 fixiert, sodass Bewegungen des Leiterelements 2, insbesondere in Längs- und/oder Umfangsrichtung, relativ zu dem Klemmkörper 5 (weitgehend) unmöglich sind. Insbesondere ist das jeweilige Leiterelement 2 in dem wenigstens einen Klemmzustand zumindest abschnittsweise, insbesondere nahezu vollständig, gegebenenfalls sogar vollständig, form- und/oder kraftschlüssig umfangsmäßig von dem Klemmkörper 5 umschlossen, woraus sich die beschriebene Klemmung bzw. Fixierung des Leiterelements 2 ergibt. Dies ermöglicht eine weitgehend homogene Krafteinwirkung auf das jeweilige Leiterelement 2, die unerwünschte Abdrücke oder Beschädigungen des jeweiligen Leiterelements 2 ausschließen.

Durch die Überführung des Klemmkörpers 5 in den wenigstens einen Nichtklemmzustand ist das Leiterelement 2 nicht (mehr) innerhalb des klemmkörperseitig begrenzten Aufnahmevolumens 5.1 fixiert, sodass Bewegungen des Leiterelements 2 relativ zu dem Klemmkörper 5 möglich sind. Das Leiterelement 2 ist in dem wenigstens einen Nichtklemmzustand sonach nicht mehr form- und/oder kraftschlüssig umfangsmäßig von dem Klemmkörper 5 umschlossen, sodass das jeweilige Leiterelement 2 auch nicht (mehr) geklemmt bzw. fixiert ist.

Der Klemmkörper 5 kann form- und/oder kraft- und/oder stoffschlüssig an dem Lagerkörper 4 befestigt sein, sodass der Klemmkörper 5 und der Lagerkörper 4 stabil miteinander verbunden sind. Form- und/oder kraftschlüssige Befestigungen können z. B. durch Klemm-, Rast-, Spann- oder Schraubbefestigungen realisiert sein. Stoffschlüssige Befestigungen können z. B. durch Klebe- oder Schweißbefestigungen realisiert sein. Der, wie erwähnt, reversibel elastisch-deformierbar ausgeführte Klemmkörper 5 kann sonach z. B. in dem Lagerkörper 4 eingeklebt sein, sodass nur die Kombination zu dem beschriebenen klemmkörperseitigen Aufnahmevolumen 5.1 führt.

An dieser Stelle ist anzumerken, dass grundsätzlich auch eine einstückige bzw. integrale Ausführung des Klemmkörpers 5 mit dem Lagerkörper 4 denkbar ist.

Der Klemmkörper 5 weist wenigstens einen mit einem, gegebenenfalls druckbeaufschlagten, Fluid - hierunter kann ein Gas und/oder eine Flüssigkeit versanden werden - befüllbaren Klemmkörperinnenraum (nicht bezeichnet) auf, wobei die Änderung des Volumens des Klemmkörpers 5 durch Befüllung des Klemmkörpers 5 mit dem Fluid herbeiführbar ist. Entsprechend können Klemmzustände und Nichtklemmzustände mit unterschiedlichen Füllzuständen des wenigstens einen Klemmkörperinnenraums mit einem jeweiligen Fluid korrelieren. Sofern der Klemmkörper 5 mehrere, gegebenenfalls miteinander kommunizierende, Klemmkörperinnenräume aufweist, können die geometrische Gestalt des Klemmkörpers 5 in jeweiligen Klemmzuständen und damit verbunden die auf den jeweiligen Leiterelementabschnitt wirkenden Klemmkräfte durch eine bestimmte Anordnung und/oder Ausrichtung der Klemmkörperinnenräume gezielt variiert werden.

Um ein entsprechendes Fluid in den wenigstens einen Klemmkörperinnenraum zuzuführen und/oder aus dem wenigstens einen Klemmkörperinnenraum abzuführen, weist der Lagerkörper 4 und/oder der Klemmkörper 5 wenigstens eine Anschlussschnittstelle 4.2, 5.2 zum Anschließen einer das Fluid bereitstellenden Fluidbereitstellungseinrichtung (nicht gezeigt) auf.

Das Überführen des Klemmkörpers 5 in jeweilige Klemm- und Nichtklemmzustände kann, wie in den Ausführungsbeispielen dargestellt, sonach hydraulisch oder pneumatisch erfolgen. Grundsätzlich kommen jedoch auch andere Prinzipien in Betracht; in diesem Zusammenhang ist lediglich beispielhaft auf mechanische, elektromechanische und/oder elektrische Aktoren zu verweisen.

Die Klemmeinrichtung 3 kann entlang bzw. um wenigstens eine Bewegungsachse in eine, gegebenenfalls auch als erste Steckstellung bezeichenbare, erste Betriebsstellung (vgl. Fig. 1, 2) und in wenigstens eine, gegebenenfalls als weitere Steckstellung bezeichenbare, weitere Betriebsstellung (vgl. Fig. 3) bewegbar gelagert sein. Bewegungen der Klemmeinrichtung 3 sind in den Ausführungsbeispielen beispielhaft dadurch realisiert, dass der Lagerkörper 4 und der Klemmkörper 5 mit einem in wenigstens einem Bewegungsfreiheitsgrad gelagerten Aufnahmekörper 15 verbunden und sonach mit diesem (bewegungs)gekoppelt sind.

Anhand der Fig. 1 - 3 ist sonach ersichtlich, dass die Klemmeinrichtung 3 in den Ausführungsbeispielen um eine Rotations- bzw. Schwenkachse A1 in eine entsprechende erste Betriebsstellung und in eine zweite Betriebsstellung verdrehbar bzw. verschwenkbar gelagert ist. Die Dreh- bzw. Schwenkachse A1 ist beispielhaft eine rechtwinklig zu einer z. B. durch die Längsachse des Lagerkörpers 4 bzw. und/oder des Klemmkörpers 5 definierten Zentralachse der Klemmeinrichtung 3 ausgerichtet. Dreh- bzw. Schwenkbewegungen der Klemmeinrichtung 3 können - wie durch den Doppelpfeil P1 angedeutet - in wenigstens einer Dreh- bzw. Schwenkrichtung grundsätzlich in einem beliebigen Winkelbereich erfolgen. Konkret zeigen die Fig. 1 -3, dass Dreh- bzw. Schwenkbewegungen der Klemmeinrichtung 3 in einem Winkelbereich von wenigstens 180° erfolgen können. Ausgehend von der in den Fig. 1, 2 gezeigten ersten Betriebsstellung kann die Klemmeinrichtung 3 sonach durch Drehen- bzw. Verschwenken um einen Winkel von wenigstens 180° in einer ersten Drehrichtung in die in Fig. 3 gezeigte zweite Betriebsstellung überführt werden. Ausgehend von der zweiten Betriebsstellung kann die Rücküberführung der Klemmeinrichtung 3 in die erste Betriebsstellung durch Drehen- bzw. Verschwenken um einen Winkel von wenigstens 180° in der ersten oder in einer zweiten Drehrichtung erfolgen. Derart kann auf einfache und praktikable Weise ein beidseitiges Setzen eines Leiterelements realisiert werden.

Anhand der Fig. ist ersichtlich, dass die Vorrichtung 1 neben der Klemmeinrichtung 3 weitere funktionelle Bestandteile aufweisen kann, welche nachfolgend beispielhaft beschrieben sind:
Die Vorrichtung 1 kann eine durch ein oder mehrere Halterungseinrichtungselemente gebildete Halterungseinrichtung 6 zur Halterung der Klemmeinrichtung 3 aufweisen. Die Halterungseinrichtung 6 kann wenigstens eine, z. B. flanschartige bzw. -förmige, Befestigungsschnittstelle zur Befestigung einer, insbesondere (elektro)motorischen, Antriebseinrichtung 7 aufweisen, welche zur Erzeugung einer die Klemmeinrichtung 3 in dem oder wenigstens einen Bewegungsfreiheitsgrad versetzenden Antriebskraft eingerichtet ist.

Weiter kann die Vorrichtung 1 eine durch ein oder mehrere Förderungseinrichtungselemente gebildete Fördereinrichtung 8 zur Förderung eines Leiterelements 2 in die Klemmeinrichtung 3 und/oder aus der Klemmeinrichtung 3 aufweisen. Die Fördereinrichtung 8 kann wenigstens eine, insbesondere (elektro)motorische, Antriebseinrichtung 9 aufweisen, welche zur Erzeugung einer ein jeweiliges Leiterelement 2 in die Klemmeinrichtung 3 und/oder aus der Klemmeinrichtung 3 fördernden Förderkraft eingerichtet ist. Fig. 1 zeigt rein beispielhaft, dass innerhalb der Fördereinrichtung 8 rollenartige Förderelemente (nicht bezeichnet) angeordnet sein können.

Weiter kann die Vorrichtung 1 eine durch ein oder mehrere, z. B. schneidenartige bzw. -förmige, Trennelemente (in Fig. 1 beispielhaft strichliert dargestellt) gebildete Trenneinrichtung 10 - diese ist nur in Fig. 1 angedeutet - zur Auftrennung eines Endlosleiters in diskrete Leiterelemente 2 aufweisen. Alternativ oder ergänzend die Trenneinrichtung 10 gegebenenfalls auch zum zumindest abschnittsweisen Abtrennen einer Isolation eines Leiterelements 2 eingerichtet sein. Die Trenneinrichtung 10 kann wenigstens eine, insbesondere (elektro)motorische, Antriebseinrichtung (nicht gezeigt) aufweisen, welche zur Erzeugung einer ein jeweiliges Trennelement in eine Trennbewegung versetzenden Trennkraft eingerichtet ist. Ersichtlich kann die Trenneinrichtung 10 beispielsweise zwischen die Klemmeinrichtung 3 und die Fördereinrichtung 8 geschaltet angeordnet oder ausgebildet sein.

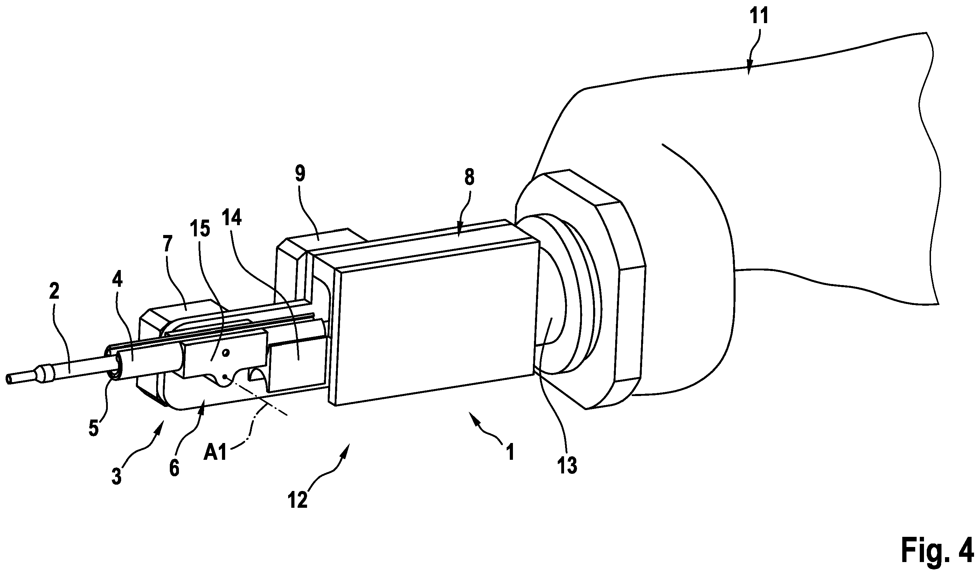

Insbesondere anhand von Fig. 4 ist ersichtlich, dass zumindest die Klemmeinrichtung 3 und die Fördereinrichtung 8 eine gemeinsam vermittels einer Manipulatoreinrichtung 11, welche z. B. einen Bestandteil eines Industrieroboters bildet, handhabbare Baugruppe 12 bilden können. Die Baugruppe 12 weist typischerweise einen durch jeweilige kanalartige Abschnitte der Klemmeinrichtung 3 und der Fördereinrichtung 8, insbesondere durch eine fluchtende Anordnung dieser, gebildeten Ausgabekanal (nicht bezeichnet) auf, über welchen ein Leiterelement 2 durch die Baugruppe 12 bewegbar ist. Entsprechende kanalartige Abschnitte sind im Falle der Klemmeinrichtung 3 durch das klemmkörperseitig begrenzte Aufnahmevolumen 5.1 gebildet.

Die Baugruppe 12 umfasst typischerweise eine Kopplungsschnittstelle 13, über welche sich die Baugruppe 12 mit einer entsprechenden Manipulatoreinrichtung 11 koppeln lässt. Die Kopplungsschnittstelle 13 ist in dem Ausführungsbeispiel beispielhaft flanschartig bzw. -förmig ausgebildet und an der Fördereinrichtung 8 angeordnet oder ausgebildet und ermöglicht eine mechanische Kopplung der Baugruppe 12 mit der Manipulatoreinrichtung 11. Eine mechanische Kopplung kann konkret z. B. durch eine Schraubverbindung realisiert sein; eine entsprechende Kopplungsschnittstelle 13 kann sonach z. B. eine Schraubverbindungsschnittstelle umfassen.

Allen vorstehend genannten Antriebseinrichtungen 7, 9 kann eine hardware- und/oder softwaremäßig implementierte Steuereinrichtung (nicht gezeigt) zugeordnet sein, über welche sich Steuerinformationen zur Steuerung des Betriebs der jeweiligen Antriebseinrichtungen 7, 9 erzeugen lassen. Entsprechende Steuerinformationen können einen kontinuierlichen, quasikontinuierlichen oder diskontinuierlichen Betrieb der jeweiligen Antriebseinrichtungen 7, 9 bedingen.

In den Fig. ist schließlich ein optionaler Stützkörper 14 angeordnet, welcher eine an die Außengeometrie des jeweiligen Leiterelements 2 angepasste Stützkontur (nicht bezeichnet) aufweist. Ersichtlich kann der Stützkörper 14 gegebenenfalls eine Anschlagfläche 14.1 für die Klemmeinrichtung 3, d. h. insbesondere den den Lagerkörper 4 und den Klemmkörper 5 aufnehmenden Aufnahmekörper 15 aufweisen, welche den Aufnahmekörper 15 und damit den Lagerkörper 4 sowie die Klemmkörper 5 in wenigstens einer Betriebsstellung stabilisieren kann.

Wenngleich in den Fig. nicht gezeigt, kann die Vorrichtung 1 mehrere Klemmeinrichtungen 3 umfassen, welche sich in den geometrisch-konstruktiven Eigenschaften der jeweiligen Lagerkörper 4 und/oder Klemmkörper 5 unterscheiden, sodass im Hinblick auf die Abmessungen eines zu setzenden Leiterelements 2 stets eine bestmöglich passende Klemmeinrichtung 3 eingesetzt werden kann. Hieraus ergibt sich, dass eine jeweilige Klemmeinrichtung 3 als austauschbares Klemmeinrichtungsmodul ausgebildet sein kann, welches z. B. mit den übrigen Bestandteilen einer entsprechenden Baugruppe 12 bedarfsweise verbunden sein kann.

Vermittels der Vorrichtung 1 lässt sich ein Verfahren zum Setzen von Leiterelementen 2, insbesondere im Zusammenhang mit einem Anschließen der Leiterelemente an ein Anschlussbauteil, implementieren. Das Verfahren umfasst zumindest die Schritte: Überführen des Klemmkörpers 5 in wenigstens einen Klemmzustand, in welchem eine Klemmkraft auf ein in dem Aufnahmevolumen 5.1 angeordneten Abschnitt eines Leiterelements 2 ausübbar ist, insbesondere vor und während des Einführens des Leiterelements 2 in eine Anschluss- oder Kontaktöffnung eines Anschlussbauteils, und/oder Überführen des Klemmkörpers 5 in wenigstens einen Nichtklemmzustand, in welchem keine Klemmkraft auf ein in dem Klemmkörpervolumen 5.1 angeordneten Abschnitt eines Leiterelements 2 ausübbar ist, insbesondere nach dem Einführen des Leiterelements 2 in eine Anschluss- oder Kontaktöffnung eines Anschlussbauteils. Die Klemmeinrichtung 3 kann im Rahmen des Verfahrens in wenigstens einem Bewegungsfreiheitsgrad bewegt werden. Ergänzend kann die Vorrichtung 1 im Rahmen des Verfahrens, insbesondere durch Kopplung mit der Manipulatoreinrichtung 11, in wenigstens einem Bewegungsfreiheitsgrad bewegt werden, um ein aus der Klemmeinrichtung 3 ragendes freies Ende eines Leiterelements 2 in eine für einen Setzvorgang zweckmäßige Ausrichtung und/oder Position relativ zu einer Anschluss- bzw. Kontaktöffnung zu verbringen.

### BEZUGSZEICHENLISTE

- 1: Vorrichtung
- 2: Leiterelement
- 3: Klemmeinrichtung
- 4: Lagerkörper
- 4.1: Aufnahmevolumen
- 4.2: Anschlussschnittstelle
- 5: Klemmkörper
- 5.1: Aufnahmevolumen
- 5.2: Anschlussschnittstelle
- 6: Halterungseinrichtung
- 7: Antriebseinrichtung
- 8: Fördereinrichtung
- 9: Antriebseinrichtung
- 10: Trenneinrichtung
- 11: Manipulatoreinrichtung
- 12: Baugruppe
- 13: Kopplungsschnittstelle
- 14: Stützkörper
- 14.1: Anschlagfläche
- 15: Aufnahmekörper

## Patentansprüche

1. Vorrichtung (1) zum Setzen von Leiterelementen (2), insbesondere im Zusammenhang mit einem Anschließen der Leiterelemente (2) an ein Anschlussbauteil, umfassend:
wenigstens eine Klemmeinrichtung (3) zum bedarfsweisen Klemmen wenigstens eines vermittels der Vorrichtung (1) zu setzenden Leiterelements (2), wobei die Klemmeinrichtung (3) wenigstens einen ein Aufnahmevolumen (4.1) zur Aufnahme eines Klemmkörpers (5) begrenzenden Lagerkörper (4) und
einen innerhalb des lagerkörperseitig begrenzten Aufnahmevolumens (4.1) angeordneten, ein Aufnahmevolumen (5.1) zur Aufnahme eines Leiterelements (2) begrenzenden volumenveränderlichen Klemmkörper (5) umfasst, welcher durch Änderung seines Volumens in wenigstens einen Klemmzustand, in welchem eine Klemmkraft auf einen in dem Aufnahmevolumen (5.1) angeordneten Abschnitt eines Leiterelements (2) ausübbar ist, und in wenigstens einen Nichtklemmzustand, in welchem keine Klemmkraft auf einen in dem Aufnahmevolumen (5.1) angeordneten Abschnitt eines Leiterelements (2) ausübbar ist, überführbar ist, wobei
der wenigstens eine Klemmkörper (5) im Gegensatz zu dem wenigstens einen Lagerkörper (4) aus einem reversibel elastisch-verformbaren Material oder einer reversibel elastisch-verformbaren Materialstruktur gebildet ist, und der wenigstens eine Klemmkörper (5) sonach reversibel deformierbar ist; und
der wenigstens eine Klemmkörper (5) wenigstens einen mit einem, gegebenenfalls druckbeaufschlagten, Fluid befüllbaren Klemmkörperinnenraum aufweist, wobei die Änderung des Volumens des wenigstens einen Klemmkörpers (5) durch Befüllung des wenigstens einen Klemmkörperinnenraums mit dem Fluid herbeiführbar ist.

2. Vorrichtung nach Anspruch 1, wobei der wenigstens eine Lagerkörper (4) und/oder der wenigstens eine Klemmkörper (5) wenigstens eine Anschlussschnittstelle (4.2, 5.2) zum Anschließen einer das Fluid bereitstellenden Fluidbereitstellungseinrichtung aufweist.

3. Vorrichtung nach einem der vorhergehenden Ansprüche, wobei die Klemmeinrichtung (3) um wenigstens eine Bewegungsachse, insbesondere Schwenkachse, in eine erste Betriebsstellung und in wenigstens eine weitere Betriebsstellung bewegbar, insbesondere verschwenkbar, gelagert ist.

4. Vorrichtung nach einem der vorhergehenden Ansprüche, wobei der wenigstens eine Lagerkörper (4) eine hohlzylinderartige Grundform aufweist, welche sich querschnittlich betrachtet in Umfangsrichtung zumindest um einen Winkelbereich von wenigstens 180°, insbesondere von wenigstens 270°, weiter insbesondere von wenigstens 300°, erstreckt.

5. Vorrichtung nach einem der vorhergehenden Ansprüche wobei der wenigstens eine Klemmkörper (5) eine hohlzylinderartige Grundform aufweist, welche sich querschnittlich betrachtet in Umfangsrichtung zumindest um einen Winkelbereich von wenigstens 180°, insbesondere von wenigstens 270°, weiter insbesondere von wenigstens 300°, erstreckt.

6. Vorrichtung nach einem der vorhergehenden Ansprüche, ferner umfassend eine Halterungseinrichtung (6) zur Halterung der Klemmeinrichtung (3), wobei die Halterungseinrichtung (6) eine Befestigungsschnittstelle zur Befestigung einer Antriebseinrichtung (7) zur Erzeugung einer die Klemmeinrichtung (3) in dem oder wenigstens einen Bewegungsfreiheitsgrad versetzenden Antriebskraft eingerichtet ist.

7. Vorrichtung nach einem der vorhergehenden Ansprüche, ferner umfassend eine Fördereinrichtung (8) zur Förderung wenigstens eines Leiterelements (2) in die Klemmeinrichtung (3) und/oder aus der Klemmeinrichtung (3).

8. Vorrichtung nach einem der vorhergehenden Ansprüche, insbesondere nach einem der Ansprüche 5 bis 7, ferner umfassend eine Trenneinrichtung (10) zur Auftrennung eines Endlosleiters in diskrete Leiterelemente (2), wobei die Trenneinrichtung (10), insbesondere zwischen die Klemmeinrichtung (3) und die Fördereinrichtung (8) geschaltet angeordnet oder ausgebildet ist.

9. Vorrichtung nach einem der vorhergehenden Ansprüche, wobei zumindest die Klemmeinrichtung (3) und/oder die Trenneinrichtung (10) und/oder die Fördereinrichtung (8) eine gemeinsam vermittels einer Manipulatoreinrichtung (11) handhabbare Baugruppe (12) bilden.

10. Verfahren zum Setzen von Leiterelementen (2), insbesondere im Zusammenhang mit einem Anschließen der Leiterelemente (2) an ein Anschlussbauteil, vermittels einer Vorrichtung (1) nach einem der vorhergehenden Ansprüche, umfassend die Schritte:
Überführen des wenigstens einen Klemmkörpers (5) in wenigstens einen Klemmzustand, in welchem eine Klemmkraft auf ein in dem Aufnahmevolumen (5.1) angeordneten Abschnitt eines Leiterelements (2) ausübbar ist, insbesondere vor und während des Einführens des Leiterelements (2) in eine Anschluss- oder Kontaktöffnung eines Anschlussbauteils, und/oder
Überführen des wenigstens einen Klemmkörpers (5) in wenigstens einen Nichtklemmzustand, in welchem keine Klemmkraft auf ein in dem Klemmkörpervolumen (5.1) angeordneten Abschnitt eines Leiterelements (2) ausübbar ist, insbesondere nach dem Einführen des Leiterelements (2) in eine Anschluss- oder Kontaktöffnung eines Anschlussbauteils.

## Claims

1. Device (1) for setting conductor elements (2), in particular in connection with connecting the conductor elements (2) to a connection component, comprising:
at least one clamping device (3) for clamping at least one conductor element (2) to be set by means of the device (1) as required, wherein the clamping device (3) comprises at least one bearing body (4) defining a receiving volume (4.1) for receiving a clamping body (5) and
a volume-variable clamping body (5) arranged within the receiving volume (4.1) delimited by the bearing body and delimiting a receiving volume (5.1) for receiving a conductor element (2), which clamping body (5) can be brought into at least one clamping state, in which a clamping force can be exerted on a section of a conductor element (2) arranged in the receiving volume (5.1) and into at least one non-clamping state in which no clamping force can be exerted on a section of a conductor element (2) arranged in the receiving volume (5.1), wherein the at least one clamping body (5), in contrast to the at least one bearing body (4), is formed from a reversibly elastically deformable material or a reversibly elastically deformable material structure, and the at least one clamping body (5) is therefore reversibly deformable; and
the at least one clamping body (5) has at least one clamping body interior that can be filled with a fluid, which may be pressurised, whereby the change in volume of the at least one clamping body (5) can be brought about by filling the at least one clamping body interior with the fluid.

2. Device according to claim 1, wherein the at least one bearing body (4) and / or the at least one clamping body (5) has at least one connection interface (4.2, 5.2) for connecting a fluid supplying the fluid.

3. Device according to one of the preceding claims, wherein the clamping device (3) is movable by at least one axis of motion, in particular pivot axis, in a first operating position and in at least one further operating position, in particular pivotable, is mounted.

4. Device according to one of the preceding claims, wherein the at least one bearing body (4) has a hollow cylinder-like basic shape, which extends cross-sectionally in the circumferential direction at least by an angular range of at least 180°, in particular of at least 270°, further in particular of at least 300°.

5. Device according to one of the preceding claims, wherein the at least one clamping body (5) has a hollow cylinder-like basic shape, which extends cross-sectionally in the circumferential direction at least by an angular range of at least 180°, in particular of at least 270°, further in particular of at least 300°.

6. Device according to one of the preceding claims, further comprising a retaining device (6) for holding the clamping device (3), wherein the retaining device (6) a fastening interface for fastening a drive device (7) for generating a the clamping device (3) in the or at least a degree of freedom of movement shifting drive force is arranged.

7. Device according to one of the preceding claims, further comprising a conveying device (8) for conveying at least one conductor element (2) into the clamping device (3) and / or out of the clamping device (3).

8. Device according to one of the preceding claims, in particular according to one of claims 5 to 7, further comprising a separating device (10) for separating a continuous conductor into discrete conductor elements (2), wherein the separating device (10) is arranged or designed to be connected in particular between the clamping device (3) and the conveyor device (8).

9. Device according to one of the preceding claims, wherein at least the clamping device (3) and / or the separating device (10) and / or the conveying device (8) form a jointly by means of a manipulator device (11) manageable assembly (12).

10. Method for setting conductor elements (2), in particular in connection with connecting the conductor elements (2) to a connecting component, by means of a device (1) according to one of the preceding claims, comprising the steps:
transferring the at least one clamping body (5) to at least one clamping state, in which a clamping force is exercisable on a portion of a conductor element (2) arranged in the receiving volume (5.1), in particular before and during the insertion of the conductor element (2) into a connection or contact opening of a connection component, and/or
transferring of the at least one clamping body (5) to at least one non-clamping state, in which no clamping force is exercisable on a portion of a conductor element (2) arranged in the clamping body volume (5.1), in particular after inserting the conductor element (2) into a connection or contact opening of a connection component.

## Revendications

1. Dispositif (1) pour mettre en place des éléments conducteurs (2), en particulier dans le cadre d'un raccordement des éléments conducteurs (2) à un composant de raccordement, comprenant :
au moins un dispositif de serrage (3) pour serrer, si nécessaire, au moins un élément conducteur (2) à poser au moyen du dispositif (1), le dispositif de serrage (3) comprenant au moins un corps de palier (4) délimitant un volume de réception (4.1) destiné à recevoir un corps de serrage (5) et
un moins un corps de serrage (5) à volume variable, disposé à l'intérieur du volume de réception (4.1) délimité du côté du corps de support et délimitant un volume de réception (5.1) destiné à recevoir un élément conducteur (2), lequel corps de serrage peut exercer, par modification de son volume, au moins un état de serrage dans lequel une force de serrage peut être exercée sur une section d'un élément conducteur (2) disposée dans le volume de réception (5.1) et dans au moins un état de non-serrage dans lequel aucune force de serrage ne peut être exercée sur une partie d'un élément conducteur (2) disposée dans le volume de réception (5.1), le au moins un corps de serrage (5) est formé, contrairement au au moins un corps de palier (4), d'un matériau déformable élastiquement de manière réversible ou d'une structure de matériau déformable élastiquement de manière réversible, et le au moins un corps de serrage (5) est donc déformable de manière réversible ; et
le moins un corps de serrage (5) comportent au moins un espace intérieur pouvant être rempli d'un fluide, éventuellement sous pression, la modification du volume du ou des corps de serrage (5) pouvant être provoquée par le remplissage de l'espace intérieur du ou des corps de serrage avec le fluide.

2. Dispositif selon la revendication 1, dans lequel au moins un corps de roulement (4) et/ou au moins un corps de serrage (5) ont au moins une interface de raccordement (4.2, 5.2) pour connecter un dispositif de distribution de fluide fournissant le fluide.

3. Dispositif selon l'une quelconque des revendications précédentes, dans lequel le dispositif de serrage (3) est articulé autour d'au moins un axe de mouvement, en particulier l'axe pivotant, dans une première position de fonctionnement et dans au moins une autre position de fonctionnement, notamment pivotant.

4. Dispositif selon l'une quelconque des revendications précédentes, dans lequel au moins un corps de roulement (4) présente une forme de base en forme de cylindre creux s'étendant transversalement, dans le sens circonférentiel, au moins autour d'une plage angulaire d'au moins 180°, en particulier d'au moins 270° et plus particulièrement d'au moins 300°.

5. Dispositif selon l'une quelconque des revendications précédentes, dans lequel au moins un corps de serrage (5) présente une forme de base en forme de cylindre creux s'étendant transversalement, dans le sens circonférentiel, au moins autour d'une plage angulaire d'au moins 180°, en particulier d'au moins 270° et plus particulièrement d'au moins 300°.

6. Dispositif selon l'une quelconque des revendications précédentes, comprenant en outre un dispositif de fixation (6) pour fixer le dispositif de serrage (3), dans lequel le dispositif de fixation (6) est équipé d'une interface de fixation pour fixer un dispositif d'entraînement (7) pour produire une force motrice qui déplace le dispositif de serrage (3) dans le ou au moins un degré de liberté de mouvement.

7. Dispositif selon l'une quelconque des revendications précédentes, comprenant en outre un dispositif de convoyage (8) pour le transport d'au moins un élément conducteur (2) dans le dispositif de serrage (3) et/ou à partir du dispositif de serrage (3).

8. Dispositif selon l'une quelconque des revendications précédentes, en particulier selon l'une quelconque des revendications 5 à 7, comprenant en outre un dispositif de séparation (10) destiné à séparer un conducteur continu en éléments conducteurs discrets (2), dans lequel le dispositif de séparation (10), notamment entre le dispositif de serrage (3) et le dispositif de convoyage (8), est placé ou formé.

9. Dispositif selon l'une quelconque des revendications précédentes, dans lequel au moins le dispositif de serrage (3) et/ou le dispositif de séparation (10) et/ou le dispositif de transport (8) forment un ensemble (12) maniable conjointement au moyen d'un dispositif manipulateur (11).

10. Procédé de mise en place d'éléments conducteurs (2), notamment en relation avec un raccordement des éléments conducteurs (2) à un composant de raccordement, au moyen d'un dispositif (1) selon l'une quelconque des revendications précédentes, comprenant les étapes suivantes:
transférer au moins un corps de serrage (5) dans au moins un état de serrage dans lequel une force de serrage peut être exercée sur une section d'un élément conducteur (2) disposée dans le volume de réception (5.1), en particulier avant et pendant l'insertion de l'élément conducteur (2) dans une ouverture de raccordement ou de contact d'un élément de raccordement, et/ou
transférer au moins un corps de serrage (5) dans au moins un état de non-serrage dans lequel aucune force de serrage ne peut être exercée sur une section d'un élément conducteur (2) située dans le volume du corps de serrage (5.1), en particulier après l'insertion de l'élément conducteur (2) dans une ouverture de raccordement ou de contact d'un composant de raccordement.
